# EUROPEAN PATENT APPLICATION

(11) **EP 3 346 265 A1**
(43) Date of publication of application: **11.07.2018**
(21) Application number: 18150500.9
(22) Date of filing: 05.01.2018
(51) Int. Cl.: G01N 27/83

(54) **PIPE INSPECTION TOOL USING COLOCATED SENSORS**

(30) Priority: 06.01.2017 US 201715400924
(71) Applicant: BAKER HUGHES, A GE COMPANY, LLC, Houston, TX 77073 (US)
(72) Inventor: FANINI, Otto, Houston, TX 77279 (US); DAOUD, Mohamed, The Woodlands, TX 77382 (US)
(74) Representative: Dehns

(57) **Abstract**

A pipe casing inspection system that combines sensor information including magnetic flux leakage from High Resolution Vertilog Tools (HRVTM) and Multi Finger Caliper (MFC) measurements. This data is used to create a model to calculate a number of metrics to gauge when the pipe will burst based on pipe corrosion, degradation, defects, damages, dents, perforations, geometry deformation, and others. The measurements can occur simultaneously and are jointly processed and interpreted to determine when the pipe will not be serviceable. Also, the measurements are taken using 3-D Electromagnetic MEM's sensor array distributed azimuthally, axially, and longitudinally.

## Description

### BACKGROUND OF THE INVENTION

### 1. Field of Invention

The present disclosure relates to operations in subterranean formations. In particular, the present disclosure relates to characterizing pipe structural deterioration associated with well fluids, stresses and environmental factors interacting with the well pipe casing using a number of colocated sensors on a pipe-inspection tool.

### 2. Description of Prior Art

In-line inspection (ILI) tools are typically used throughout the oil and gas industry to assess the integrity of pipelines by looking for defects. Many of these tools use magnetic flux leakage (MFL) measurements from a variety of sensors to inspect the potential damage in the pipelines and characterize the damage to determine what needs to be done to keep the pipeline active. Further, these sensors can detect such defects as cracking, corrosion, and other results of heavy pipe usage. MFL has been used in other methods for testing pipelines along with eddy current (EC) and electromagnetic acoustic transducer (EMAT) measurements. These methods have been combined in the past to determine various defects in pipeline walls. For instance, combining EC with MFL has been used to determine whether metal loss is on the inside diameter (ID) or outside diameter (OD) of the pipeline wall.

However there remains a strong need to improve current ILI tools and techniques in order to more reliably and accurately characterize defective pipe systems to prevent bursting. Further, in the field of ISI design, applying an external field to magnetic materials under pressure is a common way to characterize the material. One way to accomplish this is using stress-magnetization sensitivity curves. In other experiments, the use of eddy current (EC) techniques is an established method to detect, evaluate and map stresses along surfaces and structural members. The measurement principle is based on the significant changes in magnetic permeability of magnetic materials subjected to mechanical stress. Structural stresses and stress concentrations can induce or accelerate material structural corrosion that can be exhibited in but not limited to attachments, joints, seals, and solders for example.

However, in the current systems, ILI technologies can over-report or under-report damaged pipe systems and walls leading to increased down time and an decrease in profits. Therefore there is a need for an ILI system that more accurately characterizes any defects in the pipe walls so the pressure at which the pipe fails can be determined. The ultimate goal is to calculate maximum operating pressure for gas operators and other users so they can take the information to insurance providers and state regulators and the pipe pressure requirements.

### SUMMARY OF THE INVENTION

Disclosed herein is an example of a ILI tool for more accurately testing pipe structures and predicting when defects and corrosion will cause pipe bursting. Various embodiments relate to a method and apparatus for using a combination of azimuthal High Resolution Vertilog Tool (HRVTM or HRVRT) measurements, azimuthal Multi-Finger Caliper (MFC) casing inspection measurements and azimuthal sonic velocity data in order to evaluate pipe burst pressure. The HRVTM portion of the tool can be a self-contained modular pipe inspection device that is propelled through a pipeline by a fluid pressure differential along its length. The ILI pipe inspection tool includes multiple modules flexibly linked together at their respective ends to form an elongated tool. The number of modules can change depending on the size of the pipe that is under inspection. One example of a module configuration is made up of a magnetizing unit, a discriminator, an inertial measurement unit ("IMU"), a power module, a locator, and an odometer.

The tool can be cylindrical in shape and can have a plurality of circumferentially spaced sensor pads that are spring loaded. These pads can be expanded and retracted in a controlled manner, to or from the wall of the pipe that is being inspected. In an example, the magnetizing unit includes a cylindrical shaped backing bar that forms the body of this unit. Optionally, disposed on both ends of the backing bar are a pair of annular shaped magnets. The magnets can have opposite polarity and possess sufficient magnetic energy to saturate the entire pipe wall. Located on the outer diameter of each magnet is a circular spiral wound brush. Hall effect sensors are attached to the backing bar between the magnets. The Hall effect sensors are encapsulated in modules that are urged against the pipe wall by spring actuated rollers supported by various articulated arms distributed circumferentially carrying the respective inspection shoes with the Hall sensor arrays pressed against the case inner wall. Hall sensor arrays include Hall effect sensors that include a transducer that varies its output voltage in response to a magnetic field.

An embodiment of the discriminator module has a cylindrical body having a series of magnetizing units in conjunction with sensors circumferentially positioned around the body. In one example, the magnetic strength of the discriminator magnetizing units lacks sufficient magnitude to fully saturate the pipe wall thickness. In one embodiment the sensors are in imaging communication with the pipe, that is they are continuously sending out and receiving pulses that indicate the pipe structure. The magnetizing units and sensors can be located in modules that are on the end of a spring loaded pivoting arm. The spring loading arm can position the module close to the pipe wall.

Optionally located within the discriminator module are a central processing unit (CPU), a data storage device, and associated electronics. In an alternative, the CPU controls the data acquisition and storage that is obtained during use of the pipeline inspection tool.

Some embodiments of the present invention include a multi-sensor device for acquiring and processing data related to pipe wall composition. Using the data, the device can identify deformities and potential weaknesses in the pipe wall, and measure and characterize the pipe wall for use in determining potential corrosion and failure. The MFC measures the shape of the ID and detects erosion on the inner wall, indicating the deterioration of metal. This is caused by electron flow from the pipe into the flow causing wall thickness become smaller. Ovality of the pipe can also be detected by the device based on stresses on the pipe or compression.

The measurements can also indicate if the pipe is subject to being sheared by the distortion caused by the flow of the renewables or other pipe movement. This tool can measure effects due to such environmental factors as temperature gradient, which can induce corrosion or erosion. The measurements can be taken from micro-calipers next to a HRVTM tool that are ultra-sensitive and detect relative changes in the pad. The micro-calipers in some embodiments have less accuracy but higher resolution because they are smaller and can detect small changes locally and serve as quality control to the HRVTM measurements.

One embodiment includes a pipe inspection tool with an arm that supports the HRVTM sensors, where the micro-calipers are on the edge of the HRVTM sensors and have a smaller surface than the arm. In this example, micro-calipers have a smaller surface area for measurement than the HRVTM tool and can measure smaller areas such as a point along the ID of the pipe. The main pads optionally include a set of HRVTM sensors that take measurements while the micro-caliper is measuring at a different location, in front or behind or both of the HRVTM sensors. Where the HRVTM takes a measurement, all the sensors are looking at the same casing volume and area at the same time making it easier to correlate the measurements because they were looking at the same parts of the structure. The HRVTM tool detects magnetic flux leakage using MEM's EM and Hall effect sensor arrays distributed azimuthally, axially and longitudinally.

In certain embodiments, the caliper information enhances the HRVTM information. The Hall effect sensors of the HRVTM perform inspection measurements including Flux Leakage (FL). Discriminator Sensors (DIS) can also be taken into account by the tool. These measurements are often separated from caliper measurements by at least six feet. The greater the distance between the measurements, the greater the depth shifting error when placing all measurements are properly identified using the 3D accelerometer data for the tool. When the measurements are colocated and the Hall effect arrays are performed close to each other the depth shifting and error in the correction goes down.

The HRVTM tool identifies corrosion on the inside and outside of the pipe, and also detects holes through pulses. As the sensor moves along the pipe, the sensor detects the inner wall. After the sensor data is gathered, the information on the inner wall is compared to a pipe having a substantially circular cross section. To reduce the uncertainty the sensor reading is compared to a perfect inner wall and the difference is used to calculate the outer wall deterioration. An embodiment of the caliper arm has a pivot point close to the center of the pipe and a scraping spoon that is scraping the inner wall forcing the arm caliper in and out. An optional basic sensor measures the pivot relative to the central axis of the tool.

When there are multiple measurements made by the array of sensors on the HRVTM tool, there is an advantage in having the micro-caliper on the leading edge as it helps map the spacing on the inner wall. There may be voids that are filled with fluid on the inner side of the pipe and the micro-caliper helps to further capture this information. Further, the micro-caliper can help determine the wall thickness and what corrosion has occurred on the outside of the pipe wall. In the interpretation of the data, the system can use a-priori information on the structure of the pipe to reduce uncertainty concerning the pipe pressure. In some embodiments, the micro-caliper and HRVTM pads are rotating and have a line of measurements that can be attached to gyroscopic data in order to create a pipe ID and corrosion profile.

In some embodiments, the wireline has torque so at times the tool is spinning. The gyroscopic data can have plus or minus 5 degrees of accuracy, but more accurate measurements can be taken depending on the sensor setup. In some embodiments, by measuring with the multi-calipers at the same time as the HRVTM, the system provides a better indication of the wall thickness; using wall thickness as a constraint and stabilizing the HRVTM information yields a more accurate indication of the pipe deterioration. Flux Leakage (FL) surveys the entire casing cross section and therefore can be used to identify inside and outside combined pipe anomalies. The Discriminator Sensor (DIS) is a weaker magnetic measurement sensor that senses mostly to the casing volume and respective defects and corrosion at or near the inner surface of the casing. The DIS measurement is a qualitative measurement to indicate when the inner wall of the casing is contributing to the signal anomaly due to loss of casing material due to corrosion, mechanical wear, abrasion, etc. and this sensor information is compared with respect to a perfect casing. DIS sensors in combination with an FL (Flux Leakage) sensor can be used to monitor inside the pipe to identify if the pipe is punctured. The inner wall variations profile due to detected anomalies can have a finer grade of sensitivity than anomalies detected on the outside of the pipe.

Signal measurements detect the combined effect of inner and outer anomalies due to a loss of casing material. The inner surface caliper can provide an independent measurement to characterize the anomalies in the inner wall. This reduces uncertainty in the evaluation of the outer wall. When the caliper measurement is colocated with the pad inspection shoe measurement the depth shifting error is greatly reduced as mentioned above. This is primarily due to the fact that the measurements are taken at a greatly reduced distance. Other array configurations for the sensors and sensor electronic packaging can be applied to further improve the accuracy, robustness, and resolution of the measurements.

Also provided herein is a method for characterizing a pipe wall using a multi-sensor assembly, including colocated HRVTM and micro-calipers. A tool is dropped into a well in order to characterize the inner and outer surfaces of the pipe casing. The rotational rate of the device can be predicted by the micro-calipers on the trailing edge of the HRVTM. When two measurements are taken along the length of the tool, record a stream of array readings is recorded. These readings are used to determine different positions and pipe characteristics. The array does not measure the pipe at the same location, but shifts the measurement based on depth and speed of the tool.

In some embodiments, a rate of logging and pad speed is estimated by placing the micro-calipers forward and aft of the leading arm caliper. Those two measurements can be correlated to get rotational and axial velocity to determine how fast the logging of the sensor readings occurs through the zone. MEMS (Miniature Electro-Mechanical Systems) can be used with the HRVTM to detect disturbances in the pipe caused potentially by pressure, temperature, magnetic fields, and other known causes. The system can also adjust the velocity of the pad and precisely place the pads at a discrete depth to increase reading accuracy. Using the combination of the multi-caliper in addition to the HRVTM the system can identify structural anomalies on the inner and outer surfaces of the tubular.

In one embodiment the leading caliper measurements go into a table of upper and lower caliper measurements. If there is a disturbance on the upper and then the lower caliper, then the system calculates the delay and determines the placement of the multi-caliper and HVRTM. For instance if it is 200 milliseconds, the system can determine the correlation is 4 inches apart. As the tool moves through the tubular, the velocity of the cable is different than the velocity of the sensor. Another source of error is the unknown velocity of the tool as it moves through the pipe. Using the calipers the system can estimate the velocity of the tool and make calculations such that the two sensor pads are in the same zone.

Array measurement involving calipers such as micro and macro calipers and Hall sensor arrays can be performed with time tags. The array measurement features that are detected by the HVRTM arrays are time correlated to determine the delay between the other sensors in the array as they pass over the pipe casing. The array spacing is well defined to allow the proper calculation of the velocities. This information combined with the accelerometer data can be used to improve accuracy of the depth-aligned measurement so of the pipe casing.

### BRIEF DESCRIPTION OF DRAWINGS

Some of the features and benefits of the present invention having been stated, others will become apparent as the description proceeds when taken in conjunction with the accompanying drawings, in which:
FIG. 1 is a side partial cross-section view of an example of a tool in a well.
FIG. 1a is a side partial cross section close-up view of an example of the tool in a well.
FIG. 2 is a side partial cross section view of an alternate embodiment of the tool of FIG. 1.
FIG. 3 is an axial view of an embodiment of the tool of FIG. 2.
FIG. 4 is a side cross-section view of a portion of an embodiment of the tool of FIG. 1.
FIG. 5 is a side cross-section view of a portion of an embodiment of the tool of FIG. 1.
FIG. 6 is a side cross-section view of an example of a tubular having defects and includes plots that graphically represent data obtained by imaging the tubular.

While the invention will be described in connection with the preferred embodiments, it will be understood that it is not intended to limit the invention to that embodiment. On the contrary, it is intended to cover all alternatives, modifications, and equivalents, as may be included within the spirit and scope of the invention as defined by the appended claims.

### DETAILED DESCRIPTION OF INVENTION

The method and system of the present disclosure will now be described more fully hereinafter with reference to the accompanying drawings in which embodiments are shown. The method and system of the present disclosure may be in many different forms and should not be construed as limited to the illustrated embodiments set forth herein; rather, these embodiments are provided so that this disclosure will be thorough and complete, and will fully convey its scope to those skilled in the art. Like numbers refer to like elements throughout. In an embodiment, usage of the term "about" includes +/- 5% of the cited magnitude. In an embodiment, usage of the term "substantially" includes +/- 5% of the cited magnitude.

It is to be further understood that the scope of the present disclosure is not limited to the exact details of construction, operation, exact materials, or embodiments shown and described, as modifications and equivalents will be apparent to one skilled in the art. In the drawings and specification, there have been disclosed illustrative embodiments and, although specific terms are employed, they are used in a generic and descriptive sense only and not for the purpose of limitation.

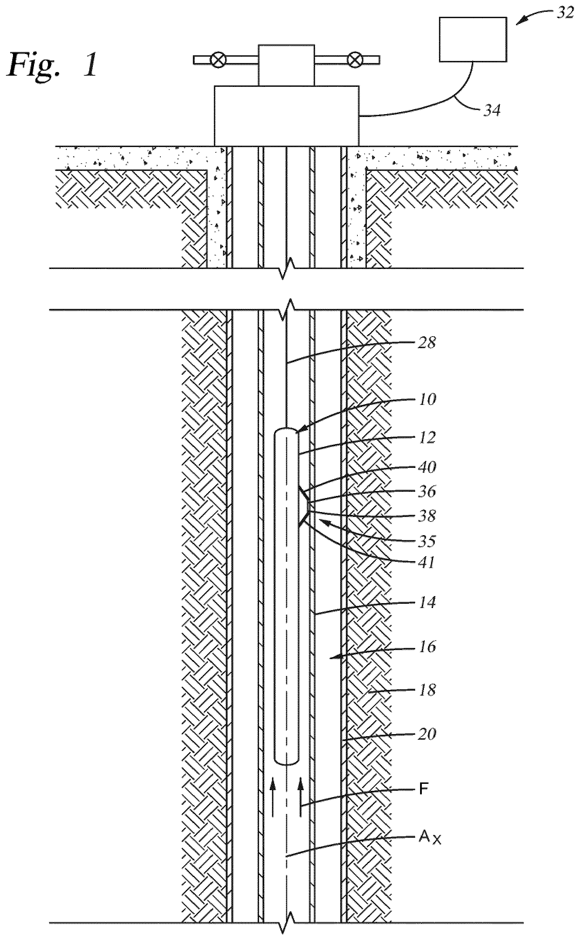

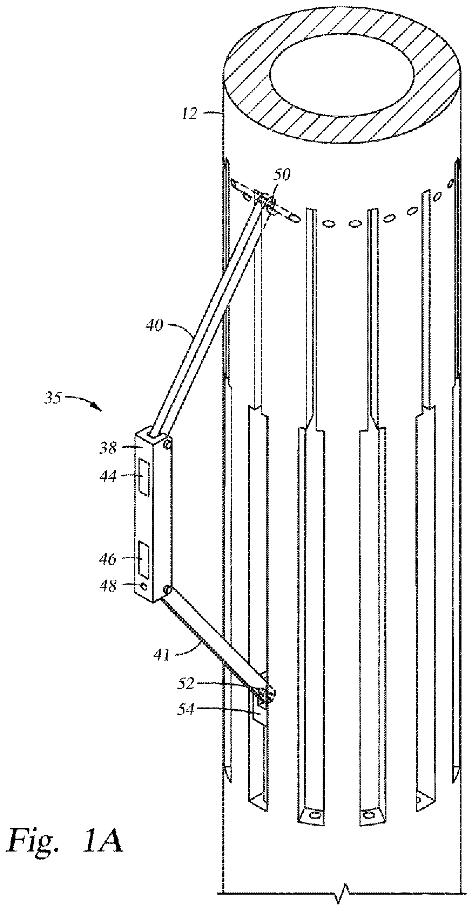

Figure 1 is a schematic example of a pipe inspection tool 10 which has an elongated housing 12 and is disposed in a length of production tubing 14. The housing 12 is shown as being generally cylindrical in shape and has a plurality of circumferentially spaced sensor pads 36 and 38 that selectively move between a stowed configuration and positioned adjacent the housing 12, to a deployed configuration positioned adjacent an inner surface of tubing 14. In one example of use and when tool 10 moves axially through tubing 14, pads 36, move in a radial direction with respect to an axis Ax of tool 10 depending on the inner surface of the production tubing 14. In this particular embodiment, tubing 14 is installed in a wellbore 16 that is shown intersecting a formation 18. Casing 20 lines the wellbore 16 and provides selective isolation of wellbore 16 from formation 18. A flow of fluid F produced from within formation 18 is shown within tubing 14 and making its way towards housing 12. The pipe inspection tool 10 can be used in any type of transportation for renewables such as downhole, mid-stream or upstream transportation.

Pipe inspection tool 10 is shown deployed within wellbore 16 on a conveyance means 28 such as, for example, wireline, tubing, or slick line. Tool 10 is deployed into the production tubing 14 on conveyance means 28. Conveyance means 28 can connect to a surface truck on the surface and disposed outside of wellbore 16. In an example, a controller 32, is included within the surface truck, and shown coupled with a communication means 34. Controller 32 selectively tracks the data gathered by the pipe inspection tool 10. Communication means 34 can include any means or devices for transmitting data or signal such as wire, fiber optics, wireless, electro-magnetic waves, and combinations thereof. In certain embodiments, communication means 34 enable communication between controller 32 and pipe inspection tool 10 via conveyance means 28. The controller 32 can be any type of information handling unit, can include a processor for processing data received from pipe inspection tool 10 as well as for transmitting instructions from the controller to the pipe inspection tool 10.

Still referring to Figure 1, an example of a pipe inspection assembly 35 is shown mounted to an outer surface of housing 12. In this example, pipe inspection assembly 35 includes an imaging pad 38 shown urged radially away from housing 12 and adjacent and inner surface of tubing 14. Embodiments exist where the pad 38 is up against and in contact with tubing 14, or spaced radially inward from tubing 14. As described in more detail below, sensors are mounted on pad 38 that interrogate the tubing 14 as the pipe inspection tool 10 is sent through the wellbore 16. Information about the tubing 14 is obtained by the interrogation, such as location and size of defects in the tubing 14 such as pitting, corrosion, divots and the like. The interrogation can further provide an estimate of a thickness of the tubing 14. Optionally, the pipe inspection tool 10 is deployed in tubulars outside of a wellbore, such as pipelines, structural members, and those used in the transportation of various fluids. Forward and aft ends of the pad 38 are respectively pivotingly coupled to caliper arms 40, 41; ends of the caliper arms 40, 41 distal from the pad 38 are coupled to housing 12.

Shown in perspective view in Figure 1A is a portion of inspection assembly 35 where pad 38 is illustrated as a generally elongate planar member and having a rectangular shaped outer periphery. Examples of sensors 44, 46 are schematically illustrated on a surface of pad 38 facing away from housing 12, which for the purposes of illustration herein is referred to as the upper surface. As further described below, example sensors 44, 46 form magnetic fields that intersect portions of the tubing 14, and monitor characteristics of the magnetic field to estimate information about the tubing 14. Further shown on the pad 38 is an optional micro-caliper 48, that in an example measures distance of a solid member from the upper surface of the pad 38. In an optional embodiment, micro-caliper 48 measures a depth, shape, and or contour of a void disposed along the inner surface of the tubing 14. Examples of voids include a crack, dent, cavity, chink, dimple, depression, or any other absence of material that creates a discontinuity of surface along the tubing 14. As shown, micro-caliper 48 is disposed on pad 38 proximate to arm 41, which for the purposes of discussion herein is referred to as an aft end. However, alternate embodiments exist where the micro-caliper 48 is disposed at any location on pad 38. Further optionally, multiple micro-calipers 48 are mounted on pad 38. Pins 50, 52 are illustrated that provide a pivoting connection between the ends of arms 40, 41 distal from pad 38 to housing 12. Optionally, pin 52 couples arm 41 to a shuttle 54, which as illustrated by arrow A, is axially slideable along an outer surface of housing 12 as assembly 35 is selectively moved between a stowed configuration, with pad 38 adjacent housing 12, to a deployed configuration, with pad 38 set radially outward from housing 12 and in a position for sensing information about tubing 14. In one embodiment, a position for sensing information about tubing 14 means in contact with or in sufficiently proximate to material being interrogated, so that the associated means for sensing obtains information about the material. In an alternate embodiment there can be a micro-caliper angular rotation sensor attached to one or both ends of the shuttle 54 and this information can be used to gain a more accurate model of the casing. In the example of a sensor with a magnetic field, a position for sensing is such that the magnetic field intersects at least a part of the material being interrogated.

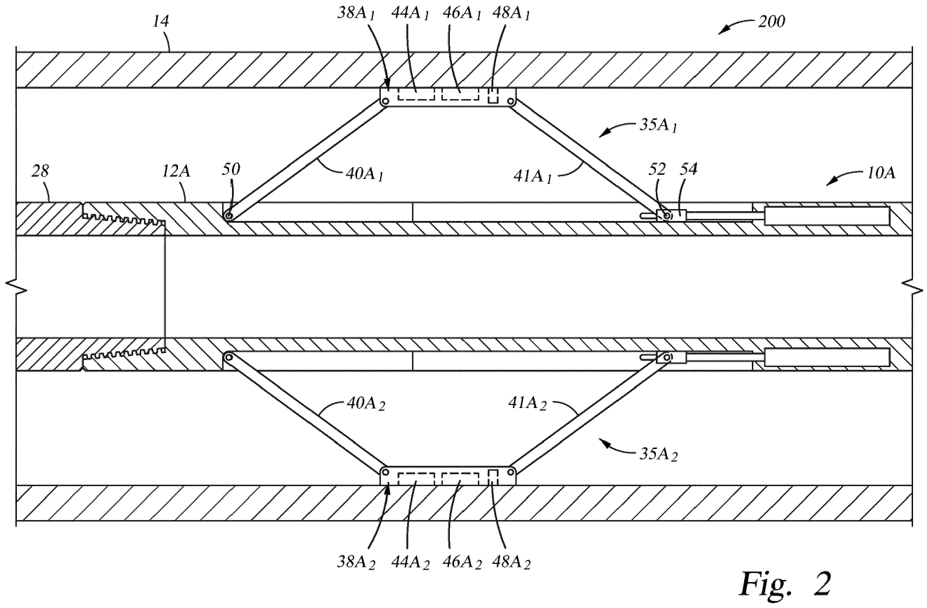

Referring now to Figure 2, shown in a side sectional view is an example of a portion of an alternate example of the pipe inspection tool 10A equipped with a pair of pipe inspection assemblies 35A_{1,2}. Here the pipe inspection assemblies 35A_{1,2} are in a deployed configuration so that the respective pads 38A_{1,2} are disposed radially outward from the housing 12A and in a position for sensing information about tubing 14. Shown in Fig. 2 is an example of a portion of an alternate embodiment of pipe inspection tool 200 and disposed inside the pipe casing 14. Caliper measuring sensor 48A_{1,2} is placed after or before HRVTM Sensors 44A_{1,2} and 46A_{1,2}. In the configuration shown, there is a micro-caliper sensor 48A_{1,2} mounted on the end of the pad 38A_{1,2}. This is not intended to limit the placement of the micro-caliper sensor 38A_{1,2} and there may be multiple micro-caliper sensors. As the tool 10A is extended down the length of the casing 14, the HRVTM Sensor 44A_{1,2} and 46A_{1,2} and the micro-caliper 48A_{1,2} take simultaneous measurements. The pad 38A_{1,2} rests on a caliper arm 54 and is attached to the tool through an arm articulation 40A_{1,2} with a spring action mechanism. The tool 10A is extended down into the well using a tool string 28.

As the tool 10A goes down the well through the tool string 28, measurements are taken using the HRVTM Sensors 44A_{1,2} and 46A_{1,2} and the micro-calipers 48A_{1,2} that are colocated. The micro-caliper measurements are then combined with the HRVTM measurements to give a more accurate reading of the strength of the pipe.

The sensors on the tool 10A gather information related to the pipe depth, ID azimuthal face correction and alignment. This can be gathered using among other sensors, gyroscopes and accelerometers. Model based joint processing of the HRVTM Sensors 44A_{1,2} and 46A_{1,2} and the micro-caliper sensors 48A_{1,2} can be used to gather the magnetic flux leakage measurements in order to increase accuracy and reduce error in computing the casing thickness for ID and OD enhancement. These measurements can be used to evaluate well pipe corrosion, degradation, defects, damages, dents, perforations, geometry deformation, ID and OD, etc.

Further, embodiments include databases that allow for storing of historical information related to pipes and testing information that can be used to predict corrosion rates and pipe deterioration progression so that a time to pipe-burst can be determined. This data can be used across the well to predict and proactively monitor pipes to anticipate problems and all of the information is stored in databases for processing.

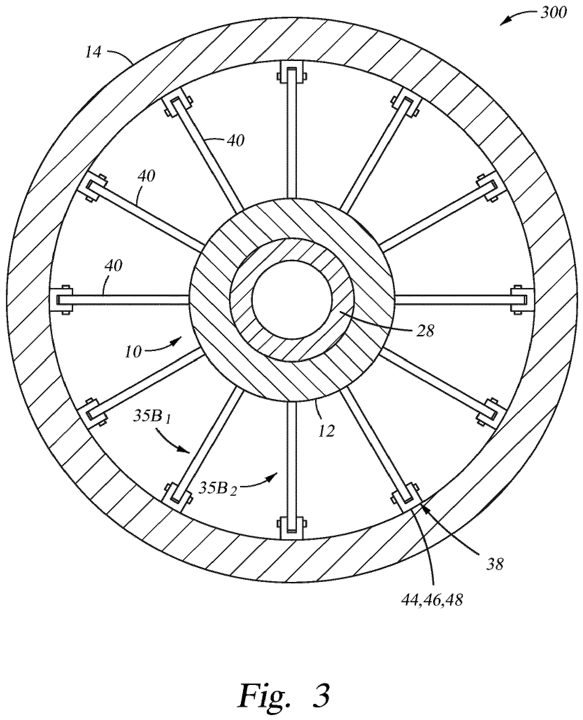

FIG. 3 shows a cross-sectional view of the assembly 300 equipped with a pair of pipe inspection assemblies 35A_{1,2}. These assemblies are repeated around the tool housing 12 in a spindle like manner as shown with the tool string 28 running through the middle of the tool housing 12. The tool is lowered into the well which is surrounded by casing 14. A set of caliper arms 40 with pads 38 HRVTM sensors 44 and 46 and colocated micro-calipers 48 touch the casing 14 at various points along the well pipe wall and allow a set of readings to be gathered.

Further, the tool enables the operator to calculate the initial enhanced pipe burst pressure based on a model recommendations such as pipe geometry, dimensions, material properties, pressure, temperature, etc. The tool also allows for the formation of azimuthal tensioncompression stress maps based on sonic pipe velocity, sonic pipe attenuation azimuthal distribution of relative ratio-metric and absolute tension at lower speeds and compression at higher speeds. These calculations can also be used in some embodiments to include given pipe thickness estimations and non-stressed nominal material properties.

The result is a model based enhanced assessment of the defects in the pipe geometry, deformation, shear and bending evaluation, buckling and torque stresses, tension and compression stresses, and other geo-mechanics information. The tool can be used to build a geo-mechanics model of the pipe that can be used to estimate geo-mechanically induced problems such as shear, subsidence, tectonic movements, and macro-stresses, geological faults and slips, fracture dynamics and other motions that can compromise pipe integrity.

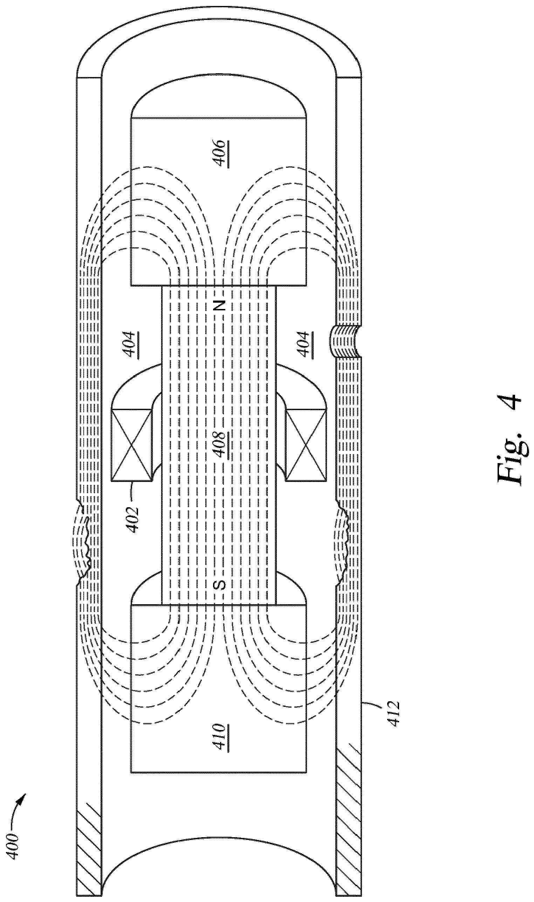

FIG. 4 is a diagram of the HRVTM 400. The HRVTM 400 includes a magnetic flux leakage detector 402. The HRVTM 400 also includes a magnetic flux leakage detector 402, a pair of flux leakage sensors 404, a back iron 408 with North and South poles, a magnet 406 at the front end of the tool 400, a magnet 410 at the back end of the tool, and a magnetic flux survey casing 412 that emanates from the Flux Leakage Sensors 404. There HRVTM is an array of Hall effect sensors that detect changes in a magnetic field.

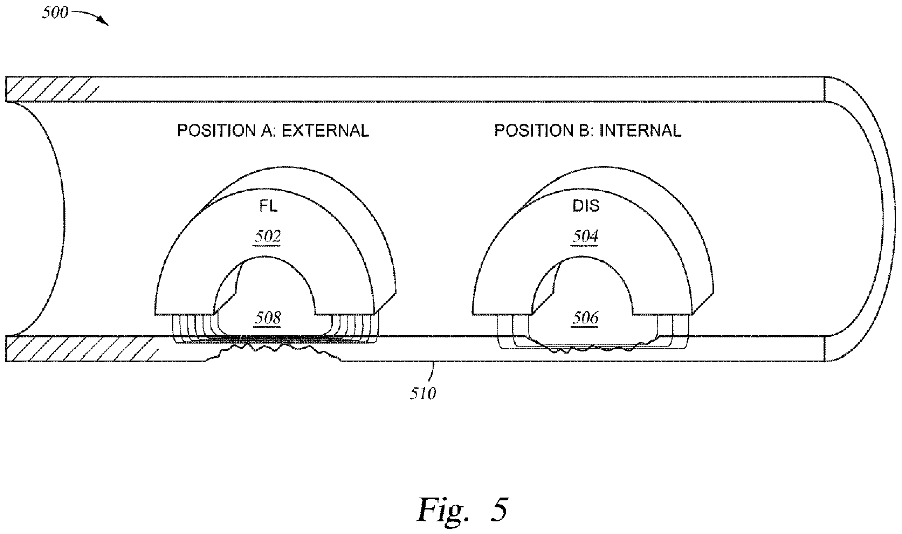

FIG. 5 shows the HRVTM 500 with a different set of magnetic flux leakage detectors. Detector FL 502 at position A detects the external magnetic flux leakage of the outer portion of pipe 510, while detector DIS 504 detects internal flux leakage at position B. The two have similar sensor locations, the DIS sensor 506 and the FL sensor 508 facing the bottom portion of the pipe 510. Other sensor positions are envisioned by the sensor arrangements.

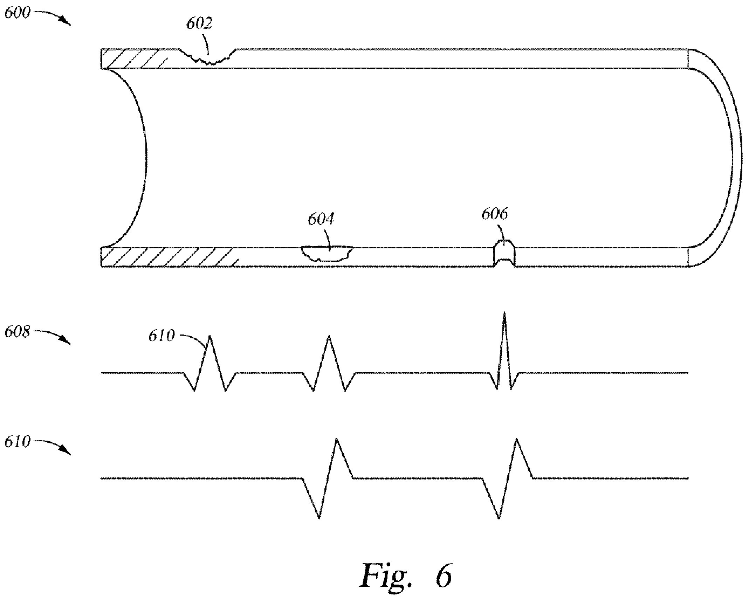

FIG. 6 shows the HRVTM tool 600 and the different waves that the sensor returns. The external defects 602 and holes 606 return back the DIS sensor wave shown in section 608. The internal defects or holes 604 are shown in the Flux Leakage sensor wave 610.

In a non-limiting example of use, the imaging and caliper sensors are used in combination to take a number of azimuthally oriented measurements and depth averaged measurements over the length of the pipe volume being evaluated. These measurements can also be taken with other measurements such as 3-D accelerometers and gyroscopic sensors to determine the face orientation inside the pipe casing. This enables each data point to be accurately mapped when measuring the deterioration of the pipe casing 14. This data is logged and stored for pro-active well integrity monitoring. 3-D azimuthally oriented pipe evaluation data can be generated based on the measurements of the sensors, and the data can be time-lapsed in order to monitor the burst-pressure of the pipe casing.

In another non-limiting example, the magnetic-flux leakage can be measured simultaneously with azimuthal sonic based pipe tension compression and defect evaluation. The multi-finger caliper data gathered by the micro-caliper can provide precise pipe ID measurements, pipe geometry, and deformation information that can be jointly interpreted with the magnetic flux leakage picked up by the HRVTM tool. These measurements are used to determine pipe integrity, degradation and identification of defects. Such indicators of wear and tear include perforations, dents, cracks, micro and macro fracture lines, and other commonly observed pipe defects. These measurements can be added to the pipe pressure burst determination in order to more accurately characterize the state of the pipe.

In another non-limiting embodiment, these measurements can also take into account the pipe material and the metallurgical properties of the pipe. Further, in some embodiments, the azimuthal sonic pipe evaluation based on the velocity and attenuation monitoring of the sensor data can provide a model based assessment of pipe geometry deformation, shear and bending evaluation based on sonic data based computations of relative metric and absolute tension and compression azimuthal stress maps given pipe thickness estimations from the sensor data. In some embodiments, geo-mechanical models of the pipe can be simulated using the gathered stress data to detect, locate, orient, and estimate geo-mechanically induced problems such as shearing, subsidence, tectonic movements, macro-stresses, geological faults and slips, fracture dynamics and other movements that comprise well and pipe integrity. Also this data can be used to predict corrosion rates, and pipe deterioration progression and aging acceleration factors. Historical data stored in well databases can be compared with the measurements gather to further characterize the defects in the pipe casing.

In one embodiment of the invention, a set of deployment pads can complement the well installation integrity evaluation performed with the Micro-Calipers (MFC) and HVRTM tools. This can be done for example to carry out a corrosion and corrosion rate assessment along with structural distortions, loss of material, structural decay and deterioration due to stress and corrosion factors due to bearing loads applied to the installation structure and downhole fluid chemical agents. These alterations and perturbation of the magnetic permeability can be detected by the deployment sensors and the signal obtained from an EC sensor can be used to inspect the material.

In one embodiment, sensors placed in the pads can generate a circumferential 2D stress map image along the inner casing surface indirectly mapping the stress via detected changes in magnetic permeability of magnetic materials. In another embodiment, a model-based numerical tool or software can be used to model, predict and interpret the EC signal obtained from a material subjected to stress. This model-based interpretation numerical tool can be a combination of a 3D finite element approach with a magneto-mechanical constitutive law describing the effect of stress on the magnetic permeability. The model can map the EC sensor impedance variation measurements as a function of stress.

The colocated pad sensors for stress evaluation can be deployed at multiple locations depending on the application and needs of the setup. These sensors can measure both applied and residual stresses in down-hole engineer installation structures in order to provide early nondestructive indications of eventual failure or failure process acceleration or deterioration rate in the downhole well integrity evaluation market. These main stress detection methods include various technologies such as: X-ray diffraction, ultrasonic techniques, eddy current (EC) techniques. The technologies that are used with the extra collocated pad sensors are useful to separate and resolve simultaneous or separate measurement effects that could be attributed to corrosion and loss of material versus magnetic permeability variation due to applied stresses changes.

One embodiment of the invention uses extra sensors to resolve whether the measurement changes are coming from stress (magnetic permeability and stress dependence - material property change) or corrosion (loss of material - structural change over time). In one embodiment, X-ray diffraction techniques are used and the measurements are based on the measurement of the lattice spacing as a strain gauge. X-ray diffraction techniques allow the user to differentiate between macro and micro-stress limited to only effective surface stresses measurement.

Further, in one embodiment, ultrasonic techniques are used and based on variations in the velocity of ultrasonic waves in the material due to tension and compression structural deformation, grooves or structural cross-section inflicted defects which have greater penetration testing depth than diffraction techniques. In another embodiment, eddy current techniques are used in the extra sensors, and are based on the measurement of changes in the impedance of an electromagnetic coil as it is coupled and scanned over a surface of conductive material as its magnetic permeability is changed by applied stress. Stress measurement including applied and residual stresses use residual magnetic field variation and its field distribution pattern around an inspected structure such as weld crack. In one embodiment, an orientation tool is used with these collocated measurements to provide time, location, depth and orientation correlation for the structural anomalies measured and detected effectively relating them to the external pipe and casings in the same well, reservoir earth formation and other well installations. These orientation measurements can be logged and stored for further use by the system.

This data is then used in some embodiments to predict when the pipe pressure could become a problem for the well. Further the two tools are colocated in order to determine the differences between structural uncertainty and material uncertainty of the pipe. There is a problem in the industry when the sensor readings pick up normal pipe stress and diagnose it as corrosion. Using the two sensors allows for a finer resolution of information to be gathered about the lattice of iron or other pipe material and whether it is disorganized due to normal stresses or actual corrosion.

In one embodiment the invention includes a multi-physics imaging service. The images that are generated by the service can be plotted side by side or jointly interpreted in any sequence that is sequentially or concurrently implemented in any combination of data measurements from the system. The service can be used for building a progressively improved image consistent with multiple observations using independent measurements and distinctive physics-based and model-based relationships. The building of the image includes cross-correlations between pipe responses to excitations and perturbations due to geometry distortions caused by structural forces and stresses (internal or external to the structure) and corrosion/erosion (material losses, wall thickness reduction). These measurements are calibrated and referenced to the cross-relations and calibrations of targeted features to be detected and interpreted from the measured data sets.

The measurements are interpreted based on orientation measurements concurrently acquired in close proximity to colocated measurements. They also can be acquired separately with an alignment reference log for orientation alignment to a structural mark with known orientation external to the structure and referenced to reservoir orientation and/or magnetic north. In one embodiment of the invention the image is processed using standard image processing algorithms and relationships known with multi-physics measurement datasets.

In one embodiment, there could be an array of sensors placed in close proximity in the pad. Different kinds of sensors can be placed in the pad or between pads or a multiple sensor array of multiple multi-physics type sensors that take various measurements can be in arrays of different sensors and sub-arrays of the same kind of sensors. These sensors can be generally located near and around pad members (including linkages) to take colocated multiple-physic measurements. Some embodiments can also include that the sensors are between pads.

## Claims

1. A system for detecting well corrosion and damages inside and outside a well pipe, the system comprising:
a housing;
a multi-finger macro-caliper or micro-caliper with a sensor in imaging communication with the surface of the pipe, and coupled with the housing; and
a magnetic flux leakage sensor that is coupled with the housing and wherein the multi-finger macro-caliper or micro-caliper is colocated and combined tool oriented with the magnetic flux leakage sensor so that when the sensor on the caliper is active and the magnetic flux leakage sensor is active, there is a simultaneous measurement from both sensors that is correlated to the same location and depth with the assistance of an orientation tool.

2. The system of claim 1, including a multi-finger macro-caliper or micro-caliper sensor array and magnetic flux leakage sensor array that are positioned axially and radially within the pipe and wherein the arrays produces a multichannel measurement for each sensor, azimuthal orientation and acquisition depth.

3. The system of claim 1, further including wherein the system calculates the time to pipe pressure burst.

4. The system of claim 1, further including wherein the system uses historical data to determine when the pipe pressure could be over a set level.

5. The system of claim 1, further including wherein the system evaluates historical and current sensor data to create recommendations for intervention or possible steps to prolong the pipe life.

6. The system of claim 1, further including wherein the system correlates and identifies similar patterns in pipes across the entire well in the reservoir.

7. The system of claim 1, further including wherein the system stores the data of every pipe in a well for further processing and comparison.

8. The system of claim 1, further including wherein the system uses collocated pad sensors to determine the pipe integrity based on magnetic permeability-stress sensitivity curves.

9. The system of claim 1, further including wherein the system uses collocated pad sensors to determine the pipe integrity assessment based on ultrasonic wave velocity-stress sensitivity curves.

10. A method for detecting well corrosion and damages inside and outside well pipes, the method comprising the steps of:
gathering data and identifying azimuthal face correction and alignment data using a magnetic flux leakage sensor and a micro-caliper or macro-caliper with a sensor;
creating a simulation model based on joint processing and interpretation assessment constraints of the gathered data by evaluating well pipe corrosion, degradation, defects, damages, dents, perforations, and geometry deformation;
calculating initial pipe burst pressure based on the created simulation model;
detecting geo-mechanically induced mechanisms that threaten pipe integrity based on an historical database; and
performing metallurgical and chemical analysis on the pipe in order to predict corrosion rates, pipe deterioration progression and aging acceleration factors associated with the well fluids, stresses and environment factors with the well pipe.

11. The method of claim 10, further comprising the step of projecting the time to pipe pressure burst.

12. The method of claim 10, further comprising the step of using the historical data to determine when the pipe pressure could be over a set level.

13. The method of claim 10, further comprising the step of evaluating the historical and current sensor data to create recommendations for intervention or possible steps to prolong the pipe life.

14. The method of claim 10, further comprising the step of correlating and identifying similar patterns in pipes across the entire well in the reservoir.

15. The method of claim 10, further comprising the steps of storing the data of every pipe in a well for further processing and comparison.
